Europäisches Patentamt

European Patent Office

Office européen des brevets

(11) Publication number: **0 409 220 A2**

# EUROPEAN PATENT APPLICATION

(21) Application number: **90113812.3**

(22) Date of filing: **19.07.90**

(51) Int. Cl.5: **H03L 7/08, H03D 13/00**

The title of the invention has been amended (Guidelines for Examination in the EPO, A-III, 7.3).

(30) Priority: **21.07.89 IT 4822089**

(43) Date of publication of application:
**23.01.91 Bulletin 91/04**

(84) Designated Contracting States:
**DE FR GB NL SE**

(71) Applicant: **SELENIA INDUSTRIE ELETTRONICHE ASSOCIATE S.p.A.**
**Via Tiburtina, KM 12.400**
**I-00131 Roma(IT)**

(72) Inventor: **Masdea, Arturo**
**Via Ugo la Malfa, 9**
**I-00040 Grotaferrata(IT)**
Inventor: **Bartolomei, Roberto**
**Via Cese, 27**
**I-00040 Ariccia(IT)**
Inventor: **Masucci, Rosanna**
**Via della Tecnica, 52**
**I-00040 Pomezia(IT)**

(74) Representative: **Gustorf, Gerhard, Dipl.-Ing.**
**Patentanwalt Dipl.-Ing. Gerhard Gustorf**
**Bachstrasse 6 A**
**D-8300 Landshut(DE)**

(54) **Phase locked loop for the extraction of a clock signal for data transmission systems.**

(57) Circuit for the extraction of a clock signal from an assigned message implemented in an analogue-digital form, essentially made up of an adaptive phase discriminator (1), a filter (2) an amplifier (3) and a VCO (4).

The invention belongs to the information and electrical communications theory field, and more precisely to that of data transmission, finding its most advantageous application in avionic, naval and groundbased systems.

FIG. 1

EP 0 409 220 A2

The invention presented regards a circuit meant to extract the clock signal from an assigned message implemented in an analogue-digital form. It makes possible the recovery of the clock in short times starting from any coded signal without the need for a preamble.

The invention pertains to the data transmission field, and more precisely to that of the electrical communications and information theory.

The circuit, subject of the invention hereby presented, is meant for application within receivers, in turn meant for transmission systems for ground, avionic and naval application.

Presently clock reconstruction problems are solved by means of devices such as:
- PIL
- EARLY-LATE GATE
- COSTAS LOOP.

Such systems have message structure limitations (PLL) or frequency (EARLY-LATE) or lock on time (COSTAS LOOP) limitations. Therefore in more general applications (transmission on avionic bus) where the compliance with the requirements above is mandatory, the conventional systems fall short and cannot be applied.

The invention presented solves all such problems with the further advantage to avionic systems having high reliability and small dimensions.

This invention has the scope of:
- extraction of the clock datum from a message which may or not be preceded by a preamble;
- operation on random data which has no particular format defined during the design phase;
- maintain a tracking error compatible with the required system specifications.

The frequency range of the device stretches from a few Hertz to tens of MegaHertz. The device is simple and can be easily implemented through ASIC or hybrid techniques.

Conventional circuits suffer of transients in the presence of random data.

This circuit modifies the clock information, adapting it to the data coming from the message, so as to have a signal devoid of asymmetric characteristics at the discriminator output which can give way to transients.

The invention will now be described for illustrative but non limiting purposes, with reference to the figures attached.

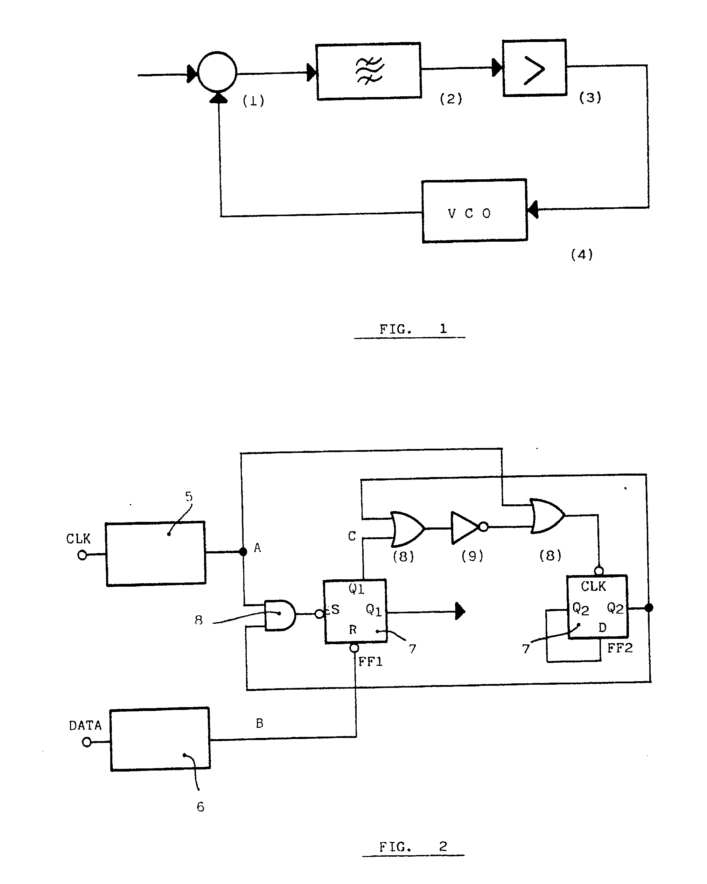

Figure 1 shows the schematic diagram of the extractor circuit.

Figure 2 shows the adaptive phase discriminator circuit. This is the most meaningful part of the invention.

In particular it shows:
- The clock positive edges 5;
- the signal positive and negative edges detector 6;
- the memory elements 7;
- the combining or elements elements 8;
- the inverter.

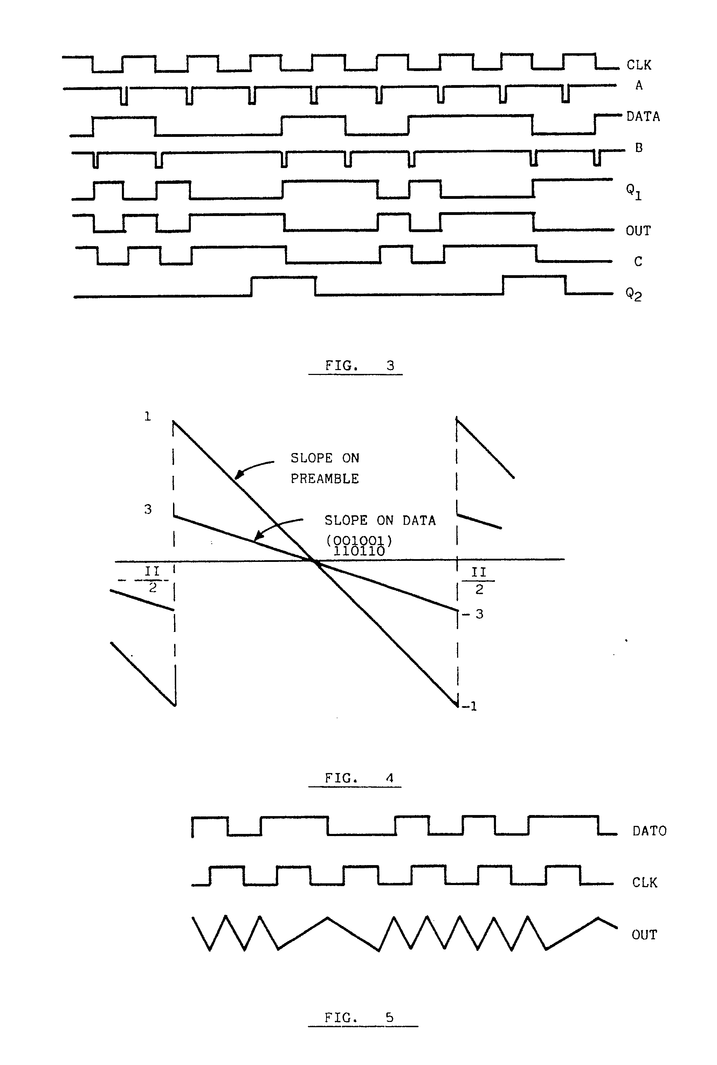

Figure 3 is the schematic diagram of the waveform at the different points indicated by the corresponding letters in figure 2.

Figure 4 is the output of the circuit in figure 2, element 7 after filtering at two gain levels associated to deterministic or random data.

Figure 5 shows the philosophy of operation of the circuit. It shows the datum, the clock and the symmetrical output waveform obtained by suitable modification of the clock as a function of the datum.

The phase discriminator modifies the clock so as to make the error signal structure symmetrical, even in the presence of a random signal. The discriminating element consists of two edge detectors 5 and 6.

The random datum modifies the output signal by passing through detector element 5, the two memory elements, the combining logic 8 and 9 and the clock now modified by detector 5. The output datum is now symmetrical and devoid of any transient in the presence of random data.

The situation described is relevant to the steady state of operation and the transient phenomena terminate during the acquisition phase only.

## Claims

1. Circuit for clock extraction starting from an assigned message to be treated by a receiver, particularly well suited for data transmission systems for application in the avionic, naval and groundbased environment, which includes an adaptive phase discriminator (1) operating on the input random datum, a filter (2), an amplifier (3) and a VCO (4).

2. Circuit for the extraction of a clock signal starting from a message for application within a receiver, particularly well suited for data transmission systems for the avionic, naval, groundbased fields, as per claim 1, where the adaptive phase discriminator is in turn made up of sequential memory elements (7) which perform modifications on the clock, logical elements (gates) 9; edge detectors (5) and (6).

FIG. 1

FIG. 2

FIG. 3

SLOPE ON PREAMBLE

SLOPE ON DATA
(001001)
110110

FIG. 4

FIG. 5

4